# EUROPEAN PATENT APPLICATION

(11) **EP 0 727 711 A2**
(43) Date of publication of application: **21.08.1996**
(21) Application number: 96300988.1
(22) Date of filing: 13.02.1996
(51) Int. Cl.: G03F 7/004

(54) **Photoresist compositions containing supercritical fluid fractionated polymeric binder resins**

(30) Priority: 17.02.1995 US 390002
(71) Applicant: OCG MICROELECTRONIC MATERIALS, INC., Cheshire, Connecticut 06410-0586 (US)
(72) Inventor: Jeffries, Alfred T., III, Providence, Rhode Island 02907 (US); Toukhy, Medhat A., Barrington, Rhode Island 02806 (US)
(74) Representative: Baker, Colin John

(57) **Abstract**

A photoresist composition comprising either an admixture or a reaction product of:
(a) at least one photosensitive compound selected from the group consisting of a photoactive compound, photo acid generators, and mixtures thereof; and
(b) at least one polymeric binder resin fractionated with a supercritical fluid.

## Description

The present invention relates to photoresists containing polymeric resins that are fractionated with a supercritical fluid.

Photoresist compositions commonly contain a polymeric binder resin and either a photoactive compound (PAC) or photoacid generator (PAG). Positive-working photoresists that contain either a mixture or a reaction product of polymeric binder resin (e.g., novolak resin) and quinonediazide photoactive compound are well known. Chemically amplified photoresists that contain a polymeric binder resin (e.g., polyhydroxystyrene or a derivative thereof) and a photoacid generator with or without a dissolution inhibitor are also well known.

Fractionated polymeric resins have been used in photoresists. The typical method of fractionating these resins is by conventional solution fractionation techniques. However, such techniques produce considerable solvent waste that must be either recycled or disposed of. Recycling of solvent waste increases the cycle time for producing the polymeric binder resin. Accordingly, solution fractionation significantly raises the cost of making such resins and the cost of the resulting photoresists containing such solution fractionated resins. Thus, there is a need for fractionated polymeric binder resins that can be used in photoresist compositions without creating considerable solvent waste. The present invention offers a solution to that need.

Separately, supercritical fluid fractionation techniques have been used for several purposes. Supercritical fluid extraction has been used to remove high-boiling impurities from polymers, e.g., poly(vinylacetate). See Chemical Abstracts 110(18):155151 p. It is also known to carry out supercritical fluid extraction of synthetic polymers to obtain high-purity polymers with a narrow molecular distribution. See Chemical Abstracts 107(12):98250 g. Also, German Patent Application DE3323940 (filed by Hoechst AG) is directed to the purification of polymers by extraction of residual monomer and the like with a supercritical gas (CO₂). Further, U.S. Patent Nos. 4,902,780 (Rhone-Poulenc); 5,034,132 (Toyo Engineering); 5,049,647 (Cobarr SPA); and 5,364,475 (State of Oregon) all teach using supercritical CO₂ to extract impurities from various polymers.

Accordingly, the present invention is directed to a method of making a photoresist composition comprising the steps of fractionating at least one polymeric binder resin with a supercritical fluid; and admixing or reacting the fractionated polymeric binder resin with at least one photoresist compound selected from a photo compound, at least one photo acid generator, and mixtures thereof.

According to a further aspect, there is provided a photoresist composition comprising either an admixture or a reaction product of:
(a) at least one photosensitive compound selected from the group consisting of a photoactive compound, a photoacid generator, and mixtures thereof; and
(b) at least one polymeric binder resin fractionated with a supercritical fluid.

The term "photoactive compounds" as employed in the present specification and claims may include any conventional photoactive compound commonly used in photoresist compositions. Quinonediazide compounds are one preferred class of photoactive compounds. Naphthaquinone diazide compounds are preferred class of species in that generic class. Examples of photoactive compounds include 2,6-bis(2,3,4-trihydroxyphenyl)methylene-4-methyl phenol (also known as 7-PyOL), which is described in Example 3 of U.S. Patent No. 4,992,356, esterified 2,6-bis(4-hydroxymethylphenyl)-4-cyclohexylphenol (3-COL) esterified to 81% of the 2D product by 1,2-naphthoquinonediazide-5-sulfonyl chloride, and 1,1-bis{[(4-hydroxy-3-methylphenyl) 1",5'-methylene]4-hydroxy-3-methylphenyl}cyclohexane (4-COL) esterified to 37% of the 2D product with 1,2-naphthoquinonediazide-5-sulfonylchloride.

"Photoacid generators" or "PAG" is used to mean compounds that form acid moieties under irradiation of UV light including the deep UV region to cleavage protecting groups from dissolution inhibitors so that the dissolution rate of the photoresist films can be increased in an exposed area to make a positive-tone photoimage. The photoacid generating compound is preferably selected from a family of the compounds which generate small acidic molecules having pKa less than 4. PAG's useful for the above purpose may be selected from various onium salts, halogen-containing compounds, and sulfonates including the following:
[I] Onium salts: Triphenylsulfonium tetrafluoroborate, Triphenylsulfonium hexafluoroantimonate, Triphenylsulfonium hexafluoroarsenate, Triphenylsulfonium hexafluorophosphate, Triphenylsulfonium trifluorosulfonate, 4-Thiophenoxydi-phenylsulfonium tetrafluoroborate, 4-Thiophenoxydi-phenylsulfonium hexafluoroantimonate, 4-Thiophenoxydi-phenylsulfonium hexafluoroarsenate, 4-Thiophenoxydi-phenylsulfonium hexafluorophosphate, 4-Thiophenoxydi-phenylsulfonium triluorosulfonate, 4-tert-Butylphenyldi-phenysulfonium tetrafluoroborate, 4-tert-Butylphenyldi-phenysulfonium hexafluoroantimonate, 4-tert-Butylphenyldi-phenysulfonium hexafluoroarsenate, 4-tert-Butylphenyldi-phenysulfonium hexafluorophosphate, 4-tert-Butylphenyldi-phenysulfonium trifluoro-sulfonate, Tris(4-methyl-phenyl)sulfonium tetrafluoroborate, Tris(4-methyl-phenyl)sulfonium hexafluoroantimonate, Tris(4-methyl-phenyl)sulfonium hexafluoroarsenate, Tris(4-methyl-phenyl)sulfonium hexafluorophosphate, Tris(4-methyl-phenyl)sulfonium trifluorosulfonate, Tris(4-methoxy-phenyl)sulfonium tetrafluoroborate, Tris(4-methoxy-phenyl)sulfonium hexafluoroantimonate, Tris(4-methoxy-phenyl)-sulfonium hexafluoroarsenate, Tris(4-methoxy-phenyl)sulfonium hexafluorophosphate, Tris(4-methoxy-phenyl)sulfonium trifluorosulfonate, Diphenyliodinium tetrafluoroborate, Diphenyliodinium hexafluoroantimonate, Diphenyliodinium hexa-fluoroarsenate, Diphenyliodinium hexafluoro-phosphate, Diphenyliodinium trifluorosulphonate, 3,3'-Dinitrodiphenyliodinium tetrafluoroborate, 3,3'-Dinitrodiphenyliodinium hexafluoroantimonate, 3,3'-Dinitrodiphenyliodinium hexafluoroarsenate, 3,3'-Dinitrodiphenyliodinium trifluorosulphonate, 4,4'-Dimethyldiphenyliodinium tetrafluoroborate, 4,4'-Dimethyldiphenyliodinium hexafluoroantimonate, 4,4'-Dimethyldiphenyliodinium hexafluoroarsenate, 4,4'-Dimethyldiphenyliodinium trifluorosulphonate.
[II] Halogen-containing compounds: 2,4,6-Tris(trichloromethyl)triazine; 2-Allyl-4,6-bis(trichloromethyl)triazine; α,β,α-Tribromomethylphenylsulfone; α,α,2,3,5,6-Hexachloroxylene; 2,2-Bis(3,5-dibromo-4-hydroxyphenyl)-1,1,1,3,3,3-hexafluoropropane; 1,1,1-Tris(3,5-dibromo-4-hydroxyphenyl)ethane.
[III] Sulfonates: 2-Nitrobenzyl tosylate; 2,6-Dinitrobenzyl tosylate; 2,4-Dinitrobenzyl tosylate; 2-Nitrobenzyl methylsulfonate; 2-Nitrobenzyl acetate; p-Nitrobenzyl 9,10-dimethoxyanthracene-2-sulfonate; 1,2,3-Tris(methanesulfonyloxy)benzene; 1,2,3-Tris(ethane-sulfonyloxy)benzene; 1,2,3-Tris(propanesulfonyloxy)benzene. These PAG may be used singly or in combination. Other suitable PAG may also be used.

Any or all polymeric binder resins commonly employed in photoresist compositions may be used herein. One preferred class of polymeric binder resins is alkali-soluble resin or resins which are useful in positive-working photoresist compositions. The term "alkali-soluble binder resin" is used herein to mean a resin which will dissolve completely in an aqueous alkaline developing solution conventionally used with positive-working photoresist compositions. Suitable alkali-soluble resins include phenolic novolaks such as phenol-formaldehyde novolak resins, cresol-formaldehyde novolak resins, or polyvinyl phenol resins, preferably those having an average molecular weight of about 500 to about 40,000, and more preferably from about 800 to 20,000.

The term "novolak resin" as used herein refers to any novolak resin which will dissolve completely in an alkaline developing solution conventionally used with positive-working photoresist composition. Suitable novolak resins include phenol-formaldehyde novolak resins, cresol-formaldehyde novolak resins, xylenol-formaldehyde novolak resins, cresol-xylenolformaldehyde novolak resins, preferably having a molecular weight of about 500 to about 40,000, and more preferably from about 800 to 20,000. These novolak resins are preferably prepared by the addition-condensation polymerization of a phenolic monomer or monomers (e.g., phenol, cresols, xylenols, or mixtures of such monomers) with an aldehyde source such as formaldehyde, chloroacetaldehyde, acetaldehyde, benzaldehyde, hydroxy benzaldehydes and are characterized by being light-stable, water-insoluble, alkali-soluble, and film-forming. One preferred class of novolak resins is formed by the addition-condensation polymerization between a mixture of meta- and para-cresols with formaldehyde having a molecular weight of about 1,000 to about 10,000. Illustrative preparations of novolak resins are disclosed in U.S. Patent Nos. 4,377,631; 4,529,682; and 4,587,196, all of which issued to Medhat Toukhy.

Other preferred novolak resins are illustrated in U.S. Patent Nos. 5,322,757 and 5,237,037.

The term "supercritical fluids" is used to describe those fluids which have been compressed beyond their critical pressure and also heated above their critical temperature. Supercritical fluids that may be used in the practice of this invention include those compounds with critical temperatures in the range of about 5°C to 150°C. Examples of fluids that may be used are nitrous oxide, carbon dioxide, light hydrocarbons, and various organic and inorganic substances. Other substances which can also be compressed and heated beyond their critical points may also be used as supercritical fluids which for the desired extraction of this invention. The preferred supercritical fluid to be used in the present process is carbon dioxide. It is technically more advantageous to use carbon dioxide because of its low T_{c} and P_{c} compared to substances with better dissolving power. Carbon dioxide is also safe, nontoxic, inexpensive, and readily available for commercial use.

The term "Modifier" is used to describe a cosolvent to be used together with a supercritical fluid. The modifiers that may be used include alcohols, ketones, and other low boiling point organic solvents. The preferred modifier is methanol. Modifiers will present in amounts in the range of 1 to 20% by weight. A mixture of modifiers can also be used.

Supercritical fluid fractionation of a polymeric binder resin, according to the present invention, encompasses the removal of undesired lower molecular weight (M_{w}) polymer chains originally present in the binder resin. Thus after this fractionation, the resulting resin will include only the higher molecular weight chains originally present in the resin. Preferably, this technique could be used to remove from about 1% to 75% of the lower molecular weight (M_{w}) polymer chains.

Preferably, the supercritical fluid fractionated polymer binder resin is from about 90% to about 40% by weight of the solids in said photoresist composition. And preferably, the photoactive compound or photoacid generating compound is from about 5% to 45% by weight of the solids of said photoresist composition.

Supercritical fluid fractionation may also be used to fractionate oligomeric or polymeric mixtures that may be useful as backbones for photoactive compounds. This fractionation will remove the lower molecular weight oligomeric chains of such oligomeric or polymer mixtures, thus leaving a more pure oligomeric or polymeric mixture. Also, impurities formed during the forming of these oligomeric backbones may be removed during this fractionation step.

The above-discussed supercritical fluid fractionated polymer binder resins are mixed with the following components to make a photoresist composition:
(1) One or more photoactive compound or photoacid generator,
(2) Optionally, one or more solvent,
(3) Optionally, dissolution inhibitors,
(4) Optionally, speed enhancers,
(5) Optionally, anti-striation agents,
(6) Optionally, anti-halation agents, and
(7) Optionally, plasticizers.
Dissolution inhibitors tend to control the dissolution rate of the photoresist composition films, particularly to inhibit the dissolution of the resist films in unexposed areas, while they can be deprotected by acid moieties generated from PAG under irradiation to enhance the dissolution rate of the resist films in exposed areas. These inhibitors are selected from various speed enhancers protected with various protecting groups such as t-BOC, THP, silyl ether group, tertiary butyl group, and so on. Preferably, the alkaline dissolution inhibitor is selected from a family of oligomeric phenolic compounds having a molecular weight from 200 to 1,000, the hydroxyl groups of which are protected with substituents which can be deprotected in the presence of acidic compounds releasing small molecules having a molecular weight from about 20 to about 100 which do not affect the dissolution of the radiation-sensitive composition in alkali developers. In particular, good candidates of the backbones of the dissolution inhibitor for this purpose may be phenolic oligomers such as 1-[1'-methyl-1'-(4'-hydroxyphenyl)ethyl]-4-[1',1'-bis(4-hydroxyphenyl)-ethyl]-phenol (also known as TRISPPA), 2,6-bis[(2,3,4-trihydroxyphenyl)methylene]-4-methylphenol, or their derivatives. Preferably, the alkaline dissolution inhibitor is from about 5% to 30% by weight of the solids of said photoresist composition.

These photoresist mixtures may also contain conventional photoresist composition ingredients such as other resins, solvents, actinic and contrast-enhancing dyes, anti-striation agents, plasticizers, speed enhancers, and the like. These additional ingredients may be added to the binder resin and photosensitive compound solution before the solution is coated onto the substrate.

Other binder resins may also be added beside the resins of the present invention mentioned above. Examples include phenolic-formaldehyde resins, cresol-formaldehyde resins, phenol-cresol-formaldehyde resins and poly(hydroxystyrene) resins commonly used in the photoresist art. Haloacetaldehyde and other aldehyde sources may be used instead of formaldehyde for making these optional resins. If other binder resins are present, they will replace a portion of the binder resins of the present invention. Thus, the total amount of the binder resin in the photoresist composition will be from about 60% to about 95% by weight of the total nonvolatile solids content of the photoresist composition.

The critical ingredients are generally dissolved in a solvent or solvents to facilitate their application to the substrate. Examples of known photoresist solvents include methoxyacetoxy propane, ethyl cellosolve acetate, n-butyl acetate, cyclopentanone, cyclohexanone, methyl ethyl ketone, diglyme, ethylene glycol monomethyl ether, ethylene glycol monoethyl ether, methyl lactate, ethyl lactate, ethyl 3-ethoxy propionate, methyl 3-methoxy propionate, ethyl pyruvate, propylene glycol alkyl ether acetates, xylene, or mixtures thereof and the like. One preferred solvent is ethyl lactate alone or in combination with ethyl 3-ethoxy propionate. The preferred amount of solvent may be from about 50 to about 500%, or higher, by weight, more preferably, from about 100 to about 400% by weight, based on combined resin and photosensitive compound weight.

Actinic dyes help provide increased resolution on highly reflected surfaces by inhibiting back scattering of light off the substrate. This back scattering causes the undesirable effect of optical notching, especially on a substrate topography. The amount of actinic dyes may be up to 10% weight levels, based on the combined weight of resin and photosensitive compound.

Contrast dyes enhance the visibility of the developed images and facilitate pattern alignment during manufacturing. Contrast dye additives may be used together with the photoresist mixtures of the present invention up to 10% weight levels, based on the combined weight of resin and photosensitive compound.

Anti-striation agents level out the photoresist coating or film to a uniform thickness. Anti-striation agents may be used up to 5% weight levels, based on the combined weight of resin and sensitizer. One suitable class of anti-striating agents is nonionic silicon-modified polymers. Nonionic surfactants may also be used for this purpose, including, for example, nonylphenoxy poly(ethyleneoxy) ethanol; octylphenoxy (ethyleneoxy) ethanol; and dinonyl phenoxy poly(ethyleneoxy) ethanol.

Plasticizers improve the coating and adhesion properties of the photoresist composition and better allow for the application of a thin coating or film of photoresist which is smooth and of uniform thickness onto the substrate. Plasticizers which may be used include, for example, phosphoric acid tri-β-chloroethyl)-ester; stearic acid; dicamphor; polypropylene; acetal resins; phenoxy resins; and alkyl resins up to 10% weight levels, based on the combined weight of resin, photosensitive compound.

Speed enhancers tend to increase the solubility of the photoresist coating in both the exposed and unexposed areas, and thus, they are used in applications where speed of development is the overriding consideration even though some degree of contrast may be sacrificed, i.e., in positive resists while the exposed areas of the photoresist coating will be dissolved more quickly by the developer, the speed enhancers will also cause a larger loss of photoresist coating from the unexposed areas. Speed enhancers that may be used include, for example, picric acid, nicotinic acid, or nitrocinnamic acid at weight levels of up to 20%, based on the combined weight of resin and sensitizer. Other known speed enhancers include polyhydroxy compounds such as resorcinol, phloroglucinol, 2,3,4-trihydroxybenzophenone, 2,3,4,4'-tetrahydroxybenzophenone, 2,3,4,3',4',5'-hexahydroxybenzophenone, acetone pyrogallol condensate resins, and the like. Preferred speed enhancers include 2,6-bis[(2,3,4-trihydroxyphenyl)methylene]-4-methylphenol, and 1-[1'methyl-1'-(4'-hydroxyphenyl)ethyl] 4-[1',1'-bis(4-hydroxyphenyl)ethyl] (also known as phenol, 4,4'-[1-[4-[1-(4-hydroxyphenyl)-1-methylethyl]phenyl]-ethylidene]bis-or TRISP-PA).

The prepared radiation-sensitive resist mixture, can be applied to a substrate by any conventional method used in the photoresist art, including dipping, spraying, whirling, and spin coating. When spin coating, for example, the resist mixture can be adjusted as to the percentage of solids content in order to provide a coating of the desired thickness given the type of spinning equipment and spin speed utilized and the amount of time allowed for the spinning process. Suitable substrates include silicon, aluminum, or polymeric resins, silicon dioxide, doped silicon dioxide, silicon resins, gallium arsenide, silicon nitride, tantalum, copper, polysilicon, ceramics, and aluminum/copper mixtures.

The use of the resist material of the present invention involves the coating of wafers to be processed. These resist materials are typically coated onto a substrate, e.g., a semiconductor based wafer such as silicon or GaAs wafer that is being processed to form semiconductor devices and exposed to ultraviolet light, electron beam, or X-ray to delineate a patterns for a subsequent process such as an etching or metallization process. It should be emphasized that during the processing of semiconductor wafers it is possible to form the photosensitive body by depositing the resist on a substrate surface that includes a semiconductor material, an insulator, such as a silicon oxide or a metal, or a combination of the semiconductor materials and insulators. Exemplary of other suitable substrates are chromium mask blanks and X-ray mask blanks. Any conventional coating process may be employed. Typically, the polymer is dissolved in a suitable solvent and the solution is filtered and then placed on the wafer to be coated, and the wafer is spun. The spinning procedure distributes the solution essentially uniformly over the surface of the wafer, and also causes the evaporation of substantially all of the solvent. In this manner, films in the thickness of about 1.0-2.0 µm (representative of thickness employed in lithography) may be produced on an appropriate substrate material.

After coating, the material is preferably prebaked to remove any remaining solvent. Pre-exposure baking temperatures in the range from 70° to 105°C for times in the range from 30 to 150 seconds are desirable. The resist material is then exposed to energy such as deep UV light, X-rays, or electron beam. Typical doses in the range from 50 to 250 mjoules/cm² for deep UV light are employed. (Corresponding doses for electron beam and X-ray irradiation are useful). Conventional exposure techniques such as described in "Introduction to Microlithography", eds. L.F. Thompson, C.G. Wilson, and M.J. Bowden, ACS Symposium, Series 219, pp. 16-82 (1983), Washington, DC, are employed to delineate the photosensitive material. It is then desirable to post-bake the exposed materials. This post-baking enhances the cleavage reaction of chain substituents with the generated acid. Generally, post-bake temperatures in the range from 70° to 115°C for time periods from 20 seconds to 30 minutes are effective. Although heating means such as a convection oven are useful, better image quality is obtained using a hot plate baking apparatus such as sold by Brewer Sciences. Solvents suitable for developing the exposed image are materials such as water/tetramethyl-ammonium hydroxide, water/NaOH or mixtures of lower alkyl alcohols such as isopropanol, ethanol, and methanol with or without water for a positive image and hexane/methylene chloride for a negative image. Generally, immersion in the developer for time periods from 20 seconds to 2 minutes produces the desired delineation.

The present invention is further described in detail by means of the following Examples. All parts and percentages are by weight and all temperatures are degrees Celsius unless explicitly stated otherwise.

### EXAMPLES

The preparation of a parent novolak and fractionated novolaks A and B are described as follows: References to M_{w} means average molecular weight and Mₙ refers to number average molecular weight as determined by gel permeation chromatography (GPC) on a Waters GPC system composed of a Waters No. 590 pump and Waters No. 410 Differential Refractometer. The eluent was tetrahydrofuran at a flow of 1 mL/min. A set of four Phenominex Phenolgel 10 columns was used; 50 A, 100 A, 500 A, and 10,000 A. PD refers to the polydispersivity, (M_{w}/Mₙ).

### PREPARATION OF PARENT NOVOLAK

A parent novolak was formed from the following reaction sequence. The reaction was conducted in a 500 ml three-neck round bottom flask fitted with a mechanical stirring apparatus, thermometer, and Fredrichs condenser. To the flask was added m-cresol (86.51 g, 0.80 mole), p-cresol (3.24 g, 0.03 mole), 2,3-xylenol (20.77 g, 0.17 mole), and 37% formalin (79.53 g, 29.43 g formaldehyde, 0.98 mole). The flask and contents were placed in a 70°C oil bath, stirring was started and oxalic acid (0.126 g) and deionized water (0.65 mL) was added in two portions at 30 minute intervals. 30 minutes after the last addition of oxalic acid dihydrate and deionized water, the temperature was raised to 115°C over 30 minutes. The solution heated at 115°C for 13.5 hours before ethyl-3-ethoxypropionate, (EEP, 11 g) was added to the solution. The apparatus was adapted for atmospheric distillation and the bath temperature was raised to 200°C over 1.5 hours and held at 200°C for 2.5 hours. After the 2.5 hour hold, the apparatus was adapted for vacuum distillation and the vacuum of the system was adjusted to 2-3 mm Hg and held at this pressure for two hours. After the pressure was increased to atmospheric, the flask and contents were removed from the oil bath and allowed to cool to room temperature. The flask and contents were treated with liquid N₂ and the broken novolak was recovered from the flask. It weighed 100.6 g, and its M_{w} by GPC was 4,882 and its Mₙ by GPC was 1,167.

### Fractionations

The parent novolak was fractionated using supercritical fluids by the Phasex Corporation, 360 Merrimac Street, Lawrence, MA 01843. A mixture of the parent novolak was fractionated by supercritical carbon dioxide which may contain a modified such as a lower alcohol, hydrocarbon, or the like. The CO₂ was compressed and heated above the critical temperature and pressure of CO₂ 34 atmospheres pressure and 31°C. The density of a supercritical fluid is greater than that of a gas but less than its corresponding liquid. The supercritical fluid supplies energy in the form of pressure which dissolves the components of the mixture. The dissolution sequence is such that lower molecular weight species dissolve first followed by species that are progressively less soluble until all the novolak has dissolved or the ability of the fluid to dissolve such material is exhausted. Different portions of the parent novolak were subjected to supercritical fluid fractionation. Novolak A had 46% of its lower molecular weight species removed and novolak B had 53% of its lower molecular weight species removed. The results of the fractionation are present in Table 1:

**Table 1--**

| Fractionation | | | |
|---|---|---|---|
| Novolak | % Removed by Fractionation | M_{w} | PD |
| A | 46 | 8,405 | 1.9 |
| B | 53 | 9,025 | 2.1 |

### PHOTORESIST PREPARATION

Six positive working photoresist compositions were prepared from the novolak resins, a photoactive compound (PAC), a speed enhancing agent (SE), a leveling agent, and coating solvents by following a general method. The novolaks used were prepared as described above. The PAC's used were 2,6-bis(4-hydroxymethylphenyl)-4-cyclohexylphenol (3-COL) esterified to 81% of the 2D product by 1,2-naphthoquinonediazide-5-sulfonyl chloride, and 1,1-bis{[(4-hydroxy-3-methylphenyl) 1",5'-methylene]4-hydroxy-3-methylphenyl}cyclohexane (4-COL) esterified to 37% of the 2D product with 1,2-naphthoquinonediazide-5-sulfonylchloride. The speed enhancers used were 2,6-bis(2-hydroxy-5-methylphenyl)methylene-4-methylphenol (p-cresol trimer) and 1-[1'-methyl-1'-(4'-hydroxyphenyl)ethyl]4-[1',1'-(hydroxyphenyl)ethyl]benzene (TRISPA). The solvents used were ethyl lactate (EL) and ethyl-3-ethoxypropionate (EEP).

The chosen novolak, photoactive compound, the speed enhancer, and solvent were mixed in the proportions as described in Table 2. The novolak letter codes refer to novolak A or B used in the formulation and the acronym in the column heading refer to PAC, speed enhancer, and solvent. The number in each column refers to the weight percent of the PAC, speed enhancer, and solvent required to make up the solids content of the particular formulation. The leveling agent (alkylresin/silicon surfactant) Fluorad FC-430 (produced by 3M) was added to give a 0.3% weight percent solution. Sufficient solvent was added to adjust the solids contents to about 24%. The final photoresist was mixed until homogeneous, and it was filtered through 0.2 micron filter. See Table 2 below:

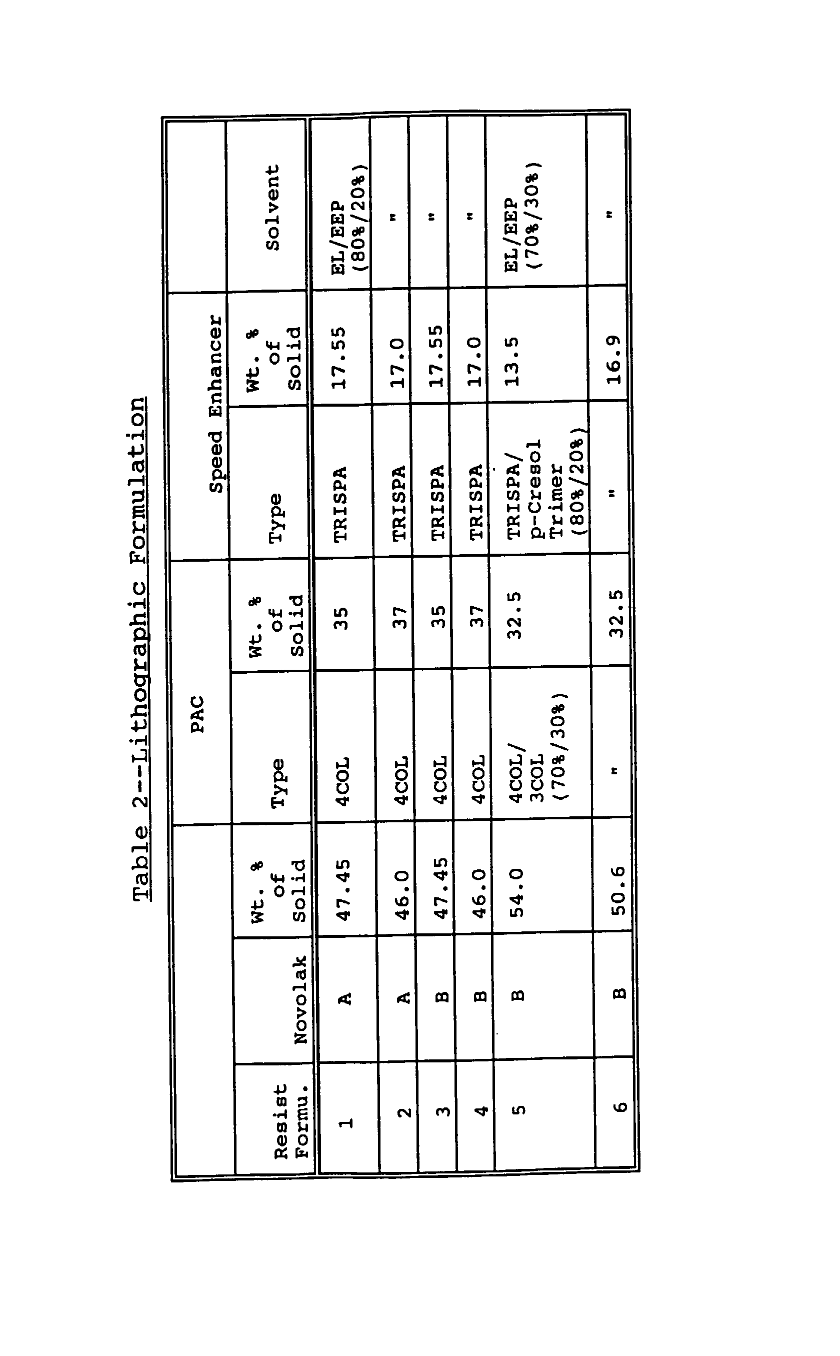

### COATING, SOFTBAKING, EXPOSURE, POST EXPOSURE BAKING, AND DEVELOPMENT OF THE PHOTORESIST

The films of the formulated photoresists were prepared for imaging exposed and developed according to the following general procedure.

The wafers were coated on a spin coater by applying 3 mL of a photoresist formulation shown on Table 2 to the static wafer. The wafer was spun at 500 rpm to spread the film and finally at 3,000 to 6,000 rpm to give a 0.98 micron film. These photoresist coated wafers were then softbaked on a vacuum chuck hotplate to 90°C for 60 seconds to remove residual solvents. The soft baked photoresist wafers were exposed for lithographic evaluation properties.

The photoresist formulations 1-4 were measured by exposing the soft baked wafers to 365 nm (i line) light using a Nikon NSR 2005i9C exposure tool with a 0.57 numerical aperture. The lithographic properties of the photoresist formulations 5 and 6 were measured by exposing the softbaked wafers to 365 nm (i-line) light using a Canon 2000I FPL exposure tool with a numerical aperture of 0.52. The exposure energy was controlled by the time a shutter was open, allowing the light to strike the photoresist film.

After completion of the exposure, the wafers were subjected to a post exposure bake (PEB) to lessen or remove standing wafers from the exposure. This was done using the vacuum chuck hot plate at 110°C for 60 seconds. Following the PEB, the photoresist coating was developed on a track system. On the track system, the wafers were spun and sprayed with 0.262 N aqueous tetramethylammonium hydroxide for 5 seconds, and the spinning was stopped for the last two seconds of the spray. The wafer remained stationary for 60 seconds while development of the latent image occurred. A deionized water rinse was applied for 20 seconds while spinning, followed by dry nitrogen gas to dry the wafer. The wafer was then ready for lithographic evaluation.

### EVALUATION OF THE PHOTORESISTS

Each imaged photoresist was evaluated for important properties. The optimum photospeed, resolution, profile, and Critical Dimension (CD) Depth of Focus (DOF), heat resistance, scumming, and profile definition are important properties. See Table 3.

The optimum exposure energy (Eopt) was determined as the energy determined to replicate the dimensions of the mask for line and space pairs. Values between 80-240 mj/cm² are acceptable while photospeeds of 130-150 mj/cm² are more desirable. A value less than 80 mj/cm² that the photoresist film is too sensitive to light while a value greater than 240 mj/cm² indicates the sensitivity is too little.

The resolution of the photoresist film is determined as the minimum line/space pair features which are cleared as Eopt. These are reported as the distance between the lines in microns. Generally, the lower the resolution values, the better the resist will perform.

The Depth of Focus (DOF) is a measure of focus latitude of the photoresist corresponding to a change in the best focus to create an image. When the focal plane of the projected images is shifted above an below the resist plane, the line space patterns created in the photoresist will become deformed due to the poor aerial image transfer. The total range (microns) in which the focus can vary and still meet the following criteria is defined as the DOF. The DOF for advanced i-line photoresist is measured at 0.35 microns.

The DOF (Profile) of the line/space patterns should be maintained consistently throughout the different focus levels. The best focus level is that which yields the minimum resolution. The width of the line of the line/space pair created as the best focus should not vary more than 10% of nominal as the focus level is changed. The DOF (Profile) at 0.35 micron line/space pairs are reported. The greater the DOF (Profile), the more desirable the photoresist becomes.

The DOF (critical dimension) or DOF (CD) is the minimum feature size for a given process the resist is required to replicate from the mask. It is required that this feature size be maintained throughout the focus and exposure window and it should not vary more than 10%. The (critical dimension) DOF is usually higher than the (Profile) DOF. The higher the DOF (CD) the more desirable the photoresist becomes.

The ability of the developed image to resist deformation due to heat generated during the process steps is known as heat resistance. This is determined by subjecting portions of the imaged wafer to a heated hot plate for 4 minutes. This is done for several temperatures (e.g., 100-150°C range). The coated wafer chip is inspected for flow of the images (i.e., image deformation) adjacent to bulk areas of the film. The temperature where significant flow of the featured sidewalls are noted is referred to as the heat resistance limit. The values of 115-120°C are considered minimum for a commercial photoresist.

The tendency of photoresist film to form scum between line/space pairs is reported as scum. Scum is the material remaining at the bottom of cleared features. While scum does not greatly influence the resolving power of photoresists, it detracts from the usefulness of the photoresist for manufacturing. Photoresist films, where little scumming was noted, were given a value of 5 on a scale of 1-5. Photoresist films demonstrating a lot of scum formation were given a rating of 1. In cases where the film was completely removed by development, no rating was given.

The profile of the line/space pairs (profile) is evaluated as the ability of the photoresist to maintain a consistent width throughout the depth of the film. Highly sloped sidewalls are undesirable and rate on a scale of 1-5. Highly vertical sidewalls are very desirable and rate a value of 5. Intermediate profiles are given a rating between the two extremes.

**TABLE 3**

| Resist Formu | Novolak | Eopt | Resolution Micron | 0.35 Micron DOF (Profile/CD) | Heat Resistance | Scum | Profile |
|---|---|---|---|---|---|---|---|
| 1 | A | <120 | NM | NM | 113°C | 5 | 5 |
| 2 | A | 140 | 0.32 | 0.9/1.0 | 113°C | 5 | 5 |
| 3 | B | 155 | 0.33 | NM | 113°C | 5 | 5 |
| 4 | B | 180 | 0.32 | 1.0/1.0 | 113°C | 5 | 5 |
| 5 | B | 236 | 0.4 | NM | NM | 5 | 3 |
| 6 | B | 300 | 0.36 | NM | NM | 5 | 3 |
| NM = Not measured | | | | | | | |

While the invention has been described above with reference to specific embodiments thereof, it is apparent that many changes, modifications, and variations can be made without departing from the inventive concept disclosed herein. Accordingly, it is intended to embrace all such changes, modifications, and variations that fall within the spirit and broad scope of the appended claims.

## Claims

1. A method of making a photoresist composition comprising the steps of:
(a) fractionating at least one polymeric binder resin with a supercritical fluid; and
(b) admixing or reacting the fractionated polymeric binder resin with at least one photoresist compound selected from a photo compound, at least one photo acid generator, and mixtures thereof.

2. A method according to claim 1 wherein the polymeric binder resin is an alkali-soluble binder resin.

3. A method according to claim 2 wherein the alkali-soluble binder resin is a novolak resin.

4. A method according to claim 1 wherein the supercritical fluid is carbon dioxide.
